(19)

Europäisches
Patentamt

European
Patent Office

Office européen
des brevets

(11) **EP 2 845 236 B1**

(12) **EUROPEAN PATENT SPECIFICATION**

(45) Date of publication and mention
of the grant of the patent:
**01.06.2016 Bulletin 2016/22**

(21) Application number: **13721633.9**

(22) Date of filing: **29.04.2013**

(51) Int Cl.:
***H01L 35/32*** (2006.01)     ***H01L 23/36*** (2006.01)

(86) International application number:
**PCT/EP2013/058897**

(87) International publication number:
**WO 2013/164307 (07.11.2013 Gazette 2013/45)**

(54) **THERMOELECTRIC CONVERSION MODULE AND METHOD FOR MAKING IT**

THERMOELEKTRISCHES UMWANDLUNGSMODUL UND HERSTELLUNGSVERFAHREN DAFÜR

MODULE DE CONVERSION THERMOÉLECTRIQUE ET SON PROCÉDÉ DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **30.04.2012 EP 12166123**

(43) Date of publication of application:
**11.03.2015 Bulletin 2015/11**

(73) Proprietor: **Université Catholique de Louvain
1348 Louvain-la-Neuve (BE)**

(72) Inventors:
• **JACQUES, Pascal
B-1457 Tourinnes-saint-lambert (BE)**
• **SIMAR, Aude
B-1300 Wavre (BE)**

• **VAN DER REST, Camille
B-1450 Blanmont-Chastre (BE)**
• **MATAGNE, Ernest
B-5081 Bovesse (BE)**
• **ROY, Geoffrey
B-5030 Gembloux (BE)**
• **SHMITZ, Alain
B-4920 Aywaille (BE)**

(74) Representative: **De Groote, Christophe et al
Abyoo sprl
Centre Monnet
Avenue Jean Monnet, 1
1348 Louvain-la-Neuve (BE)**

(56) References cited:
JP-A- 2006 108 253     JP-A- 2007 273 572
US-A1- 2005 013 119     US-A1- 2007 220 902

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

### Field of the invention

According to a first aspect, the invention relates to a thermoelectric module. According to a second aspect, the invention relates to an assembly of at least two thermoelectric modules. According to a third aspect, the invention relates to a process for making a thermoelectric module.

### Description of prior art

A major part of energy waste in industrial and domestic applications takes the form of thermal energy. High temperature (>400 °C) rejected gases can be efficiently used. However, there is a big challenge in using rejected gases that have a lower temperature. Thermoelectric converters or thermal conversion modules using the Seebeck effect could be used in order to generate electric energy from such a source of thermal energy. Thermoelectric converters can be used in other applications; for instance they can be used to convert into electricity geothermal energy, heat from sun or heat from the seas. Using the Peltier effect, thermoelectric converters can also be used to generate heat or coldness from electricity.

JP 2007273572 discloses a thermoelectric module.

US2011/0226304 discloses a thermoelectric module that comprises p-type and n-type elements that are bonded to each others. In order to add the electric voltages induced in each of the n-type and p-type elements by the Seebeck effet, each p-type element is bonded to an n-type element with an electrically insulating material in a second region of a junction surface joining each p-type and n-type element. Hence, the p-type and n-type elements of this thermoelectric module are electrically connected in series whereas they are thermally connected in parallel. The fabrication of such a thermoelectric module is not simple as it requires the presence of such an electrically insulating material between each p-type and n-type element along a part of the junction surface joining each p-type and n-type element. Moreover, such a configuration is not adapted when one aims at having a thermoelectric module having the form of a layer or a plate with a small thickness because of the two following reasons. First, the electric voltage takes place over the thickness of each p-type or n-type element of the thermoelectric module in this case. If the thickness is small one cannot hope to have a large temperature difference between the upper and the lower surfaces of the thermoelectric module, and so to have a large induced electric voltage. Second, one needs to insert along a part of the junction surface joining each p-type and n-type element said electrically insulating material. Such an insertion renders the process of fabrication quite elaborate when the thickness of the thermoelectric module decreases.

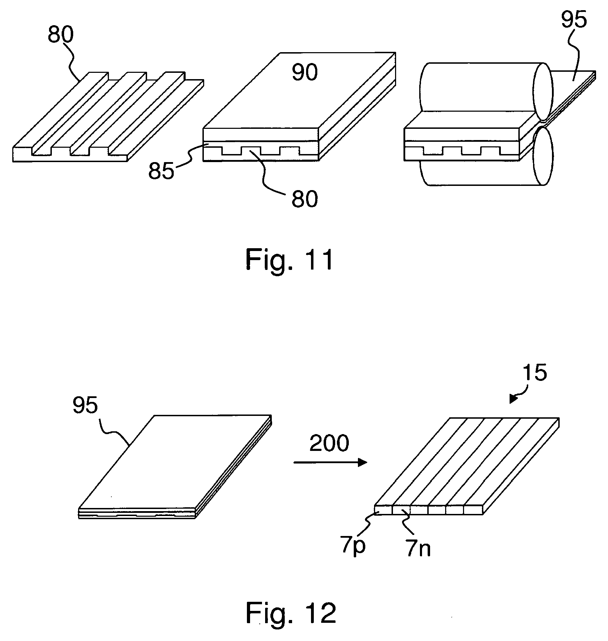

Figure 12 of WO2005/020340 proposes another geometry of a thermoelectric module. In this case, n-type and p-type elements are bonded to each other through shunts. As one can learn from line 23 of page 27, some shunts are cooled whereas others are heated. A thermal flux having a component parallel to the arrow 1209 of figure 12 takes place in the p and n-type elements. Contrary to the geometry of US2011/0226304, the electric current follows a straight line in this case and crosses the shunts separating each p-type and n-type elements. The shunts of this geometry are used to transport heat. Such shunts are not adapted if one aims at having a thermoelectric module that has the form of a plate or a layer. Indeed, the shunts of figure 12 extend at each side of the p and n-type elements in order to carry heat. The shunts shown in this figure 12 significantly increase the global thickness of the thermoelectric module. As known by the one skilled in the art, a thermoelectric module having the form of a layer has various advantages. One of them is to have a compact thermoelectric module that can be inserted around a chimney for instance. The presence of a shunt between each n-type and p-type element significantly increases the difficulty of processing a thermoelectric module having the form of a layer. Moreover, the shunts of the thermoelectric module of figure 12 of WO2005/020340 induce electric contact resistances along the way of the electric current induced by the electric voltage due to the Seebeck effect. Such electric contact resistances appear as there are different contacts between different elements (between the shunts and the p/n-type elements). Because of these electric contact resistances, there is a loss of energy in the thermoelectric module and finally a loss of efficiency of the thermoelectric module.

### Summary of the invention

It is an object of the present invention to provide a thermoelectric module that can take the form of a layer and that can be processed more easily with respect to known thermoelectric conversion modules. To this end, the inventors propose a thermoelectric module comprising:

- a thermoelectric layer of substantially constant thickness, t, comprising one p-type portion and one n-type portion, both portions presenting together an upper and a lower main surfaces separated by said thickness t and extending over the whole thickness t of the thermoelectric layer;
- a first and a second thermal resistor elements in thermal contact with said lower main surface;
- a first thermal bridge element in thermal contact with said lower main surface, between and adjacent to the first and second thermal resistor elements;

such that said first and second thermal resistor elements and said first thermal bridge element cover the whole lower main surface, and such that said first thermal bridge element is globally able to transfer heat between said thermoelectric layer and the surrounding environment at a substantially higher rate than the first and second thermal resistor elements.

The thermoelectric module of the invention is characterized in that:

- said p-type and said n-type portions are adjacent and directly coupled by an interface; and in that
- said first thermal bridge element spans at least over the orthogonal projection of said interface onto said lower main surface.

The thermoelectric module of the invention can take the form of a layer or a plate; this means that one dimension (the thickness) of the thermoelectric module can be much smaller than the other dimensions. Indeed, the thermoelectric layer, the first and second thermal resistor elements and the first thermal bridge element can each have a small thickness resulting in a thermoelectric module of small thickness. Even by choosing a small thickness t of the thermoelectric layer, one can obtain a non negligible electric voltage generated by the thermoelectric module. Indeed, from the specific position of the first thermal bridge element with respect to the first and second thermal resistor elements, a thermal flux that has a component perpendicular to the thickness t of the thermoelectric layer is induced in it if this thermoelectric layer is subjected to a temperature gradient between its upper and lower main surfaces. Hence, there will be an induced electric voltage in the thermoelectric layer having a component that is perpendicular to its thickness t. Because of the specific position of the first thermal bridge element with respect to the first and second thermal resistor elements, the component of the thermal flux that is perpendicular to the thickness t of the thermoelectric layer has opposite directions in the p-type and n-type portions when the thermoelectric layer is subjected to a temperature gradient between its lower and upper parts (the lower part is adjacent to the lower main surface of the thermoelectric layer and the upper part is adjacent to the upper main surface of the thermoelectric layer). Hence, the electric voltages that are generated in the p-type and n-type portions have a component perpendicular to the thickness t of the thermoelectric layer with a same direction. Finally, the electric voltages perpendicular to the thickness t generated in the p-type and n-type portions add and do not subtract to each other. Preferably, the first and second thermal resistor elements are continuous as well as the first thermal bridge element.

Contrary to the thermoelectric modules disclosed in US2011/0226304 and in WO2005/020340, neither any electrically insulating material nor shunt is needed between the p-type and n-type portions (elements) for the thermoelectric module of the invention. In particular, the p-type and n-type portions of the thermoelectric module of the invention are in contact all along the interface that crosses the substantially constant thickness t: in other words, there is no intermediate material that links the p-type and n-type portions in the thermoelectric module of the invention. Hence, its process of fabrication is easier or simpler. The global geometry of the thermoelectric module is simple and is adapted to take the form of a plate or a layer. This can reduce the cost of fabrication of the thermoelectric module of the invention with respect to known thermoelectric conversion modules. As mentioned before, a thermoelectric module having the form of a layer has other advantages such as to obtain a compact thermoelectric module that can be easily inserted around a chimney for instance.

Contrary to the thermoelectric modules proposed in US2011/0226304 and in WO2005/020340, one can imagine a continuous process of fabrication for making the thermoelectric module of the invention. By locally changing the doping of a thermoelectric layer, one can obtain the p-type and n-type portions of the thermoelectric layer. A continuous process of fabrication allows one to obtain thermoelectric modules of large dimensions. Another advantage of a continuous process of fabrication is to reduce the costs of fabrication. The thermoelectric module of the invention has other advantages. Neither wire nor conductor is needed for electrically connecting the p-type and n-type portions. An electric current is indeed able to flow through the interface between the p-type and n-type portions. As there is no shunt between p-type and n-type portions, there are no corresponding electric contact resistances between such shunts and the p-type/n-type portions (contrary to the thermoelectric module disclosed in WO2005/020340). The absence of electric contact resistances can lead to an increase of efficiency up to 20% of the thermoelectric module. Thanks to the geometry of the thermoelectric module of the invention, a large number of such thermoelectric modules can be easily assembled from a continuous fabrication process, resulting in a large thermoelectric converter that can take the form of a plate or of a cylinder for instance. Hence, the thermoelectric module of the invention allows obtaining large, low cost thermoelectric converters.

Preferably, the first thermal bridge element has a third thermal conductivity, $\kappa_3$, that is higher than the thermal conductivities of said first and second thermal resistor elements (1 r, 2r), $\kappa_1$ and $\kappa_2$.

As the first thermal bridge element has a higher thermal conductivity than the first and second thermal resistor elements, it is able to transfer heat between the thermoelectric layer and the surrounding environment at a substantially higher rate than the first and second thermal resistor elements do.

Preferably, said p type portion and said n type portion have substantially the same volume, and each of said first and second thermal resistor elements covers at least 30% of said lower main surface.

As each of the first and second thermal resistor elements covers at least 30% of the lower main surface of the thermoelectric layer, the first thermal bridge element covers maximum 40% of the lower main surface of the thermoelectric layer. Hence, if the thermoelectric module is subjected to a temperature gradient between its upper and lower parts, a significant percentage of the heat flux traversing the thermoelectric layer will have to follow a trajectory having a component perpendicular to the thickness t of the thermoelectric layer. Such an embodiment increases the component of the generated electric voltage in a direction perpendicular to the thickness t of the thermoelectric layer.

Preferably, the thermoelectric layer has a breadth B; and the p-type and n-type portions extend over substantially the whole breadth B.

Preferably, the thickness t of the thermoelectric layer is comprised between 1 mm and 10 mm. Such a value of the thickness t of the thermoelectric layer is a good comprise between having a significant temperature gradient between the upper and lower main surfaces of the thermoelectric layer and the possibility of having a compact thermoelectric module of small thickness. However, a larger or a smaller thickness t is possible. As an example, the thickness t can be comprised between 1 and 100 $\mu$m, and is preferably equal to 10 $\mu$m.

Preferably, the thermoelectric module further comprises:

- a third thermal resistor element in thermal contact with said upper main surface;
- a second and third thermal bridge elements in thermal contact with said upper main surface;

wherein:

- said third thermal resistor element is able to transfer heat between said thermoelectric layer and the surrounding environment at a substantially lower rate than second and third thermal bridge elements;
- said third thermal resistor element and said second and third thermal bridge elements cover the whole upper main surface; and wherein
- said third thermal resistor element spans at least over the orthogonal projection of said electrical interface onto said upper main surface.

In this embodiment, the thermoelectric module of the invention comprises an additional thermal resistor element and additional thermal bridge elements. Such an embodiment allows still increasing the component of the thermal flux that is perpendicular to the thickness t of the thermoelectric layer when the lower and upper parts of the thermoelectric module are subjected to a temperature gradient. In other words, the component of the thermal flux that is parallel to the thickness t of the thermoelectric layer is further reduced in this embodiment. Hence, the component of the generated electric voltage that is perpendicular to the thickness t of the thermoelectric module can be larger with this embodiment. Preferably, the second and third thermal bridge elements are continuous as well as the third thermal resistor element.

Preferably, said third thermal resistor element has a fourth thermal conductivity, $\kappa_4$, that is lower than the thermal conductivities of said second and third thermal bridge elements, $\kappa_5$ and $\kappa_6$.

Preferably, said third thermal resistor element covers at least 50% of the orthogonal projection of said first thermal bridge element on said upper main surface.

Preferably, said third thermal resistor element covers at least 100% of the orthogonal projection of said first thermal bridge element on said upper main surface. In this embodiment no thermal flux can cross directly the thermoelectric layer along a direction that is parallel to its thickness t. Indeed, the third thermal resistor element covers at least 100% of the orthogonal projection of the first thermal bridge element. This ensures having a large component of the thermal flux that is perpendicular to the thickness t of the thermoelectric layer, and finally obtaining a generated electric voltage that has a large component perpendicular to the thickness t of the thermoelectric layer.

Preferably, said first, second and third thermal resistor elements comprise a same thermally insulating material of thermal conductivity $\kappa_r$, and said first, second and third thermal bridge element elements comprise a same thermally conductive material of thermal conductivity $\kappa_c$, and such that $\kappa_r < \kappa_c$. The fabrication of this embodiment of the thermoelectric module is still easier as the first, second, and third thermal resistor elements comprise a same thermally insulating material, and as the first, second, and third thermal bridge elements comprise a same thermally conductive material.

Preferably, said thermoelectric layer comprises a Fe,V,Al-based material.

Choosing a thermoelectric layer comprising a Fe, V, Al-based material presents different advantages. First, iron (Fe) and aluminium (Al) are relatively cheap elements that are available in large quantity. Adding vanadium (V) to the Fe and Al elements allows obtaining an alloy with a relatively high Seebeck coefficient and that can be doped for obtaining p-type and n-type portions. There exist different doping processes for a $Fe_2VAl$ material.

According to a second aspect, the invention relates to an assembly of a first and a second thermoelectric modules where:

- the upper and lower main surfaces of the first thermoelectric module are continuous with respectively the upper and lower main surfaces of the second thermoelectric module; and where
- the n-type portion of the first thermoelectric module is electrically and mechanically coupled to the p-type portion of the second thermoelectric module.

According to a third aspect, the invention relates to a method for making a thermoelectric module and comprising the following steps :

(a) forming a multilayer material comprising at least two layers of at least a first and a second materials;
(b) heating this multilayer material such that the at least two materials of the at least two layers are blended by diffusion in order to obtain a thermoelectric layer comprising an upper and a lower main surfaces separated by the thickness t thereof;
(c) coupling a first and second thermal resistor elements, and a first thermal bridge element in thermal contact with one main surface of said thermoelectric layer, wherein said first thermal bridge element is able to transfer heat between said thermoelectric layer and the surrounding environment at a substantially higher rate than the first and second thermal resistor elements.

Preferably, the multilayer material is formed in step (a) by a roll bonding process.

Preferably, the multilayer material is formed in step (a) by performing the following steps:

- providing a first layer of a first material, a second layer of a second material, and a third layer of a third material such that the melting temperature of the second material, $T_{m,2}$, is lower than the melting temperatures of the first and third materials, $T_{m,1}$ and $T_{m,3}$, and where the first, second and third layers each have an upper surface and a lower surface;
- forming a layup by stacking the first, second and third layers such that the upper surface of the second layer contacts at least a portion of the lower surface of the first layer, such that the lower surface of the second layer contacts at least a portion of the upper surface of the third layer, and such that the contact portions of the upper and lower surfaces of the second layer with the first and third layers, respectively, overlap at least partially;
- pressing and translating over at least a friction portion of the upper surface of the first layer a rotating tool to raise the temperature of said friction portion of the upper surface of the first layer by friction and to conduct heat through the thickness, $t_1$, of the first layer to the second layer such that the temperatures reached by at least the overlapping portions of the upper and lower surfaces of the second layer are higher than the second melting temperature $T_{m,2}$ thereof.

**Short description of the drawings**

These and further aspects of the invention will be explained in greater detail by way of examples and with reference to the accompanying drawings in which:

Fig.1      schematically shows a first embodiment of the thermoelectric module according to the invention;

Fig. 2      schematically shows the direction of the heat flux in the thermoelectric layer and the direction of the induced electric current when the upper part of the thermoelectric module is subjected to a higher temperature than its lower part;

Fig. 3      schematically shows a preferred embodiment of the thermoelectric module according to the invention;

Fig. 4      schematically shows another preferred embodiment of the thermoelectric module according to the invention;

Fig. 5      schematically shows the direction of the heat flux in the thermoelectric layer and the direction of the induced electric current for the preferred embodiment shown in the previous figure when the upper part of the thermoelectric module is subjected to a higher temperature than its lower part;

Fig. 6      schematically shows another preferred embodiment of the thermoelectric module according to the invention;

Fig. 7      schematically shows another preferred embodiment of the thermoelectric module according to the invention;

Fig. 8      shows a preferred embodiment of an assembly comprising two thermoelectric modules according to the invention;

Fig. 9      shows another preferred embodiment of an assembly comprising thermoelectric modules according to the invention;

Fig. 10      shows another preferred embodiment of an assembly comprising thermoelectric modules according to the invention;

Fig. 11      illustrates a procedure that is used for locally inducing stoichiometry variations of a multilayer material;

Fig. 12      illustrates the thermoelectric layer obtained after a heat treatment applied to a multilayer material;

Fig. 13      schematically shows rolls pressing a plate by a roll bonding process in order to obtain a multilayer layer;

Fig. 14      schematically shows a preferred technique for forming a multilayer material.

The figures are not drawn to scale. Generally, identical components are denoted by the same reference numerals in the figures.

**Detailed description of preferred embodiments**

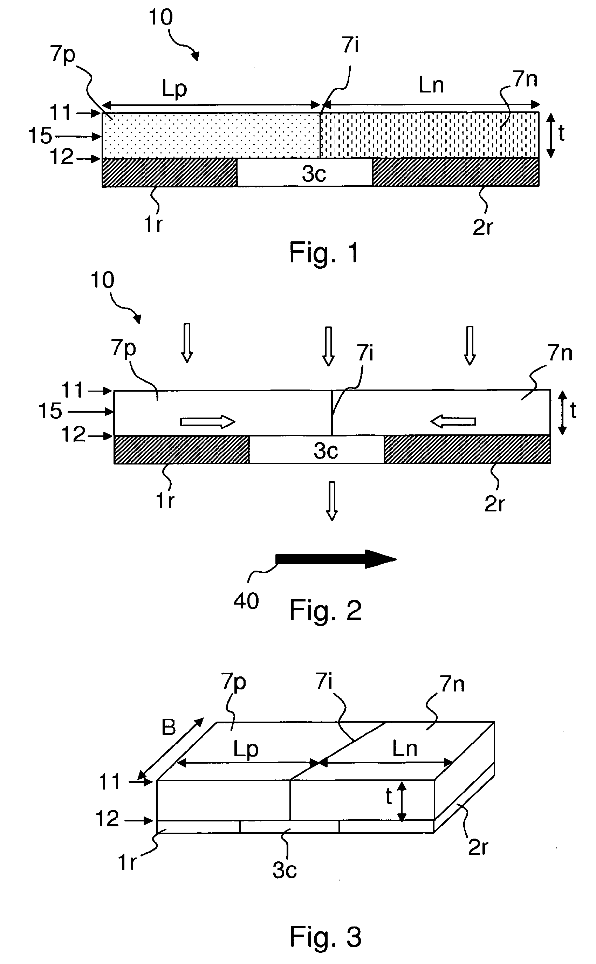

Figure 1 shows a first embodiment of the thermoelectric module 10 according to the invention. The thermoelectric module 10 comprises a thermoelectric layer 15 of substantially constant thickness t. The thermoelectric layer 15 comprises an upper 11 and a lower 12 main surfaces that are separated by the thickness t. The thermoelectric layer 15 also comprises one p-type 7p and one n-type 7n portions. Each portion (7p, 7n) extends over the whole thickness t of the thermoelectric layer 15. Preferably, the whole thermoelectric layer 15 is made of a same material that presents a spatial variation of its doping in order to obtain the p-type 7p and n-type 7n portions. The terms 'p-type' and 'n-type' are known by the one skilled in the art. In another preferred embodiment, the p-type 7p and n-type 7n portions are made of two different materials. The thickness t is preferably comprised between 1 mm and 10 mm, and is more preferably equal to 8 mm. However, a larger or a smaller thickness t is possible. As an example, the thickness t can be comprised between 1 and 100 $\mu$m, and is preferably equal to 10 $\mu$m. As shown in figure 1, the p-type 7p and n-type 7n portions are adjacent (or contiguous) and directly coupled by an interface 7i. So, contrary to the module shown in figure 12 of WO2005/020340, there is neither a shunt nor a joining material between the p-type 7p and n-type 7n portions. When the whole thermoelectric layer 15 is made of a single material, this material can be a semimetal or a semiconductor for instance. These terms are known by the one skilled in the art. When the thermoelectric layer 15 comprises a single semiconductor, the interface 7i represents the transition between p-type 7p and n-type 7n portions. When the thermoelectric layer comprises a single semiconductor, the interface 7i preferably represents an electrical interface between the p-type 7p and n-type 7n portions (the p-type (respectively n-type) portion comprises a concentration of holes (respectively electrons) that is larger than a concentration of electrons (respectively holes)). An electrical interface in a semiconductor junction is a volume (or very small thickness) wherein the concentration of p-type carriers (holes) equals the concentration of n-type carriers (electrons); in this electrical interface, holes and electrons concentrations are equal to the intrinsic concentration $n_i$. The term intrinsic concentration $n_i$ is known by the one skilled in the art.

The thermoelectric module 10 of the invention further comprises a first and second thermal resistor elements, 1 r and 2r, that are in thermal contact with the lower main surface 12 of the thermoelectric layer 15. A first thermal bridge element 3c is also in thermal contact with this lower main surface 12 of the thermoelectric layer 15. This first thermal bridge element 3c is adjacent to and positioned between the first and second thermal resistor elements, 1 r and 2r. These three elements (1 r, 3c, 2r) cover the whole lower main surface 12 of the thermoelectric layer 15 as shown in figure 1. The first thermal bridge element 3c is able to transfer heat between the thermoelectric layer 15 and the surrounding environment at a substantially higher rate than the first and second thermal resistor elements, 1r and 2r, do. The first thermal bridge element 3c is able to transfer heat between the thermoelectric layer 15 and the surrounding environment at a rate that is preferably equal to or larger than 2 times, and more preferably larger than 5 times, the rate at which the first and second thermal resistor elements, 1 r and 2r, transfer heat between the thermoelectric layer 15 and the surrounding environment. Hence, if the upper main surface 11 of the thermoelectric layer 15 is subjected to a higher temperature than the lower main surface 12 of the thermoelectric layer 15, a thermal flux from the upper main surface 11 to the lower main surface 12 follows the open arrows of figure 2 (such arrows would be in an opposite direction if the lower main surface 12 were subjected to a higher temperature than the upper main surface 11). Hence, the thermal flux that crosses the thermoelectric layer 15 has a component that is perpendicular to thickness t of the thermoelectric layer 15 and such a component has opposite directions in the p-type 7p and n-type 7n portions. As such component of the thermal flux in the p-type 7p and n-type 7n portions have opposite directions, the components of voltages induced in the two portions (7p, 7n) and that are perpendicular to the thickness t of the thermoelectric layer 15 have a same direction. As known by the one skilled in the art, each material indeed possesses a Seebeck coefficient, S, that is expressed in volts (V) per Kelvin (K):

$$S = \Delta U / \Delta T \text{ (Eq. 1),}$$

where $\Delta U$ represents the voltage generated by a temperature difference $\Delta T$ in the material. As defined by the one skilled in the art, S is negative for n-type materials and positive for p-type materials. Hence, the induced voltages in the p-type 7p and n-type 7n portions of the thermoelectric layer of figure 2 add and induce an electric current having a direction parallel to that of the black arrow 40 shown in figure 2. As a consequence, by providing electric contacts at the p-type 7p and the n-type 7n portions, one can recover electric power generated by the thermoelectric module 10 when it is subjected to a heat difference between its upper and lower main surfaces (11,12). As shown in same figure 2, the first thermal bridge element 3c spans at least over the orthogonal projection of the interface 7i onto the lower main surface 12.

Different reasons can cause that the first thermal bridge element 3c is able to transfer heat between the thermoelectric layer 15 and the surrounding environment at a substantially higher rate than the first and second thermal resistor elements (1 r, 2r) do. These different reasons are linked to different preferred embodiments of the thermoelectric module 10 of the invention that present different thermal properties. In a preferred embodiment, this rate difference in heat transfer is due to different thermal conduction properties of the first and second thermal resistor elements (1 r, 2r) and the first thermal bridge element 3c: in this preferred embodiment, the first thermal bridge element 3c comprises a material that has a third thermal conductivity, $\kappa_3$, that is higher than the thermal conductivities of the first and second thermal resistor elements (1 r, 2r), $\kappa_1$ and $\kappa_2$. Hence, in this preferred embodiment, $\kappa_3 > \kappa_1$, and $\kappa_3 > \kappa_2$. Preferably, the first and second thermal resistor elements (1 r, 2r) comprise aluminium oxide, glass (silicate), or polymer. Preferably, first and second thermal resistor elements (1 r, 2r) are electrical insulators which means that they have an electric resistivity higher than $10^{10}$ $\Omega*$m, more preferably higher than $10^{12}$ $\Omega*$m, and still more preferably higher than $10^{16}$ $\Omega*$m. Preferably, the first thermal bridge element 3c comprises a material that is an electrical conductor such as copper. Using a first thermal bridge element 3c comprising a material that is an electrical conductor allows having a higher generated power. Internal resistance of the generator is reduced in this case.

In another preferred embodiment, the rate difference in heat transfer is due to different thermal radiation properties of the first and second thermal resistor elements (1 r, 2r) and the first thermal bridge element 3c. So, in this preferred embodiment, the first thermal bridge element 3c is able to transfer heat by radiation between the thermoelectric layer 15 and the surrounding environment at a higher rate than the first and second thermal resistor elements (1 r, 2r) do.

In a still preferred embodiment, the first thermal bridge element 3c is able to transfer heat between the thermoelectric layer 15 and the surrounding environment at a higher rate than the first and second thermal resistor elements (1 r, 2r) do because of different convection properties. In this preferred embodiment, the first thermal bridge element 3c preferably comprises air and the first and second thermal resistor elements (1r, 2r) are typically solid elements that are also preferably good thermal insulators then also reducing heat transfer by conduction and radiation. Hence, one can combine different conduction, radiation and convection properties of the first thermal bridge element 3c and the first and second thermal resistor elements (1 r, 2r) in order to obtain the desired property that the first thermal bridge element 3c is able to transfer heat between the thermoelectric layer 15 and the surrounding environment at a higher rate than the first and second thermal resistor elements (1r, 2r) do.

Different processes can be used for joining the first thermal bridge element 3c and the first and second thermal resistor elements (1 r, 2r) to the thermoelectric layer 15. The elements (3c,1 r,2r) can be deposited on the thermoelectric layer 15 by lithography or any other printing technique for instance. When oxides are used as thermal insulators for the first and second thermal resistor elements (1 r, 2r), one can obtain such layers by local oxidation for instance. Alternatively the first thermal bridge element 3c and the first and second thermal resistor elements (1 r, 2r) can be joined to the thermoelectric layer 15 by gluing. Such techniques are known by the one skilled in the art.

Preferably, the p-type 7p and n-type 7n portions extend over substantially the whole breadth B of the thermoelectric layer. The breadth B can be non constant.

This preferred embodiment is shown in figure 3.

Values of different parameters of the thermoelectric module 10 that result from optimization calculations are now presented. These preferred values can lead to a higher efficiency of the thermoelectric module 10 of the invention. Preferably, the thickness t of the thermoelectric layer 15 is comprised between 1 and 10 mm. More preferably, thickness t of the thermoelectric layer 15 is equal to 8 mm. However, a larger or a smaller thickness t is possible. As an example, the thickness t can be comprised between 1 and 100 $\mu$m, and is preferably equal to 10 $\mu$m. Preferably, the lengths Lp and Ln of the p-type 7p and of the n-type 7n portions (see figure 1) are constant over the breadth B. More preferably, Lp and Ln are comprised between 90 and 250 mm. Still more preferably, Lp = 242 mm and Ln = 244 mm over the whole breadth B. However, larger or smaller values of Lp and Ln are possible. Preferably, the first and second thermal resistor elements (1 r,2r) cover at least 30 % of the lower main surface 12. Hence, if Lp + Ln ~ 500 mm over the whole breadth, the lengths of the first and second thermal resistor elements (1r,2r) in a direction parallel to the black arrow 40 of figure 2 are typically larger than 150 mm.

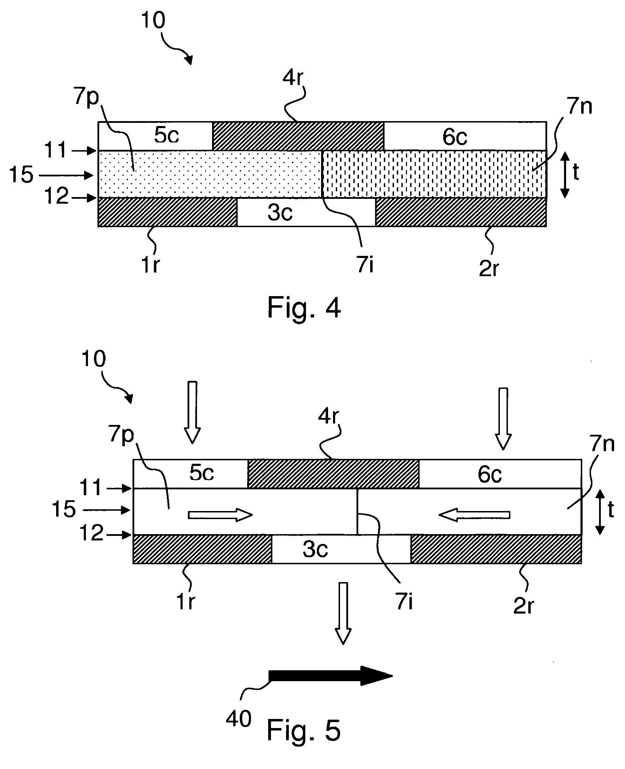

Figure 4 shows another preferred embodiment where the thermoelectric module 10 further comprises a third thermal resistor element 4r and a second and third thermal bridge elements (5c, 6c). These three additional elements (4r, 5c, 6c) are in thermal contact with the upper main surface 11 of the thermoelectric layer 15. The third thermal resistor element 4r is able to transfer heat between the thermoelectric layer 15 and the surrounding environment at a substantially lower rate than the second and third thermal bridge elements (5c, 6c). As explained above, such a feature can be due to different conduction, radiation or convection properties between these three elements (4r, 5c, 6c). As shown in figure 4, the third thermal resistor element 4r and the second and third thermal bridge elements (5c, 6c) cover the whole upper main surface 11 of the thermoelectric layer 15. The third thermal resistor element 4r spans at least over the orthogonal projection of the electrical interface 7i on the upper main surface 11. Preferably, second and third thermal bridge elements (5c, 6c) are electrical conductors.

Figure 5 schematically shows the direction of heat transfer (or heat fluxes) when this preferred embodiment undergoes a temperature gradient such that the upper main surface 11 is subjected to a higher temperature than the lower main surface 12. Because of the presence of the different elements (1 r, 2r, 4r, 3c, 5c, 6c) thermal flux has to follow the open arrows of figure 5. Hence, as in figure 2, a component of the thermal flux perpendicular to thickness t of the thermoelectric layer 15 takes place in the thermoelectric layer 15 and has opposite directions in the p-type 7p and n-type 7n portions. As components of the thermal flux in the p-type 7p and n-type 7n portions that are perpendicular to the thickness t of the thermoelectric layer 15 have opposite directions, the induced voltages in these two portions (7p, 7n) have a same direction inducing an electric current flowing in a direction parallel to the black arrow 40 of figure 5.

Preferably, the third thermal resistor element 4r has a fourth thermal conductivity $\kappa_4$, that is lower than the thermal conductivities of the second and third thermal bridge elements (5c, 6c), $\kappa_5$ and $\kappa_6$. Preferably, the third thermal resistor element 4r covers at least 50% (and more preferably at least 100%) of the orthogonal projection of the first thermal bridge element 3c on the upper main surface 11 of the thermoelectric layer 15. Preferably, the first, second and third thermal resistor elements (1 r, 2r, 4r) comprise a same thermally insulating material of thermal conductivity $\kappa_r$, and the first, second and third thermal bridge element elements (3c, 5c, 6c) comprise a same thermally conductive material of thermal conductivity $\kappa_c$, and such that $\kappa_r < \kappa_c$. Such a thermally insulating material is preferably aluminium oxide, glass (silicate), or polymer. Preferably, the first, second, and third thermal resistor elements (1 r,2r,4r) comprise a material that is an electric insulator which means that it presents an electric resistivity higher than $10^{10}$ $\Omega$*m, more preferably higher than $10^{12}$ $\Omega$*m, and still more preferably higher than $10^{16}$ $\Omega$*m.

Preferably, the thermal gradient imposed between the upper and lower main surfaces (11,12) of the thermoelectric layer 15 is equal to 400 °C.

Preferably, the thermoelectric layer 15 of any of the preferred embodiments described above comprises a Fe,V,Al-based material. Such a material is less brittle than other thermoelectric materials such as ceramics. Fe,V,Al-based material also presents the advantage of having a relatively high electric conductivity while presenting a moderate thermal conductivity. By an appropriate doping of such a Fe,V,Al-based material, one can obtain p-type and n-type regions. The doping of the Fe,V,Al-based material also allows increasing the absolute value of the Seebeck coefficient, S. For obtaining a n-type (respectively p-type) portion, one can add silicon (respectively titanium) to a $Fe_2VAl$ material for instance. For obtaining a Fe,V,Al-based thermoelectric layer with n-type 7n and p-type 7p portions, one can also locally induce local stoichiometry variations in the alloy $Fe_2VAl$.

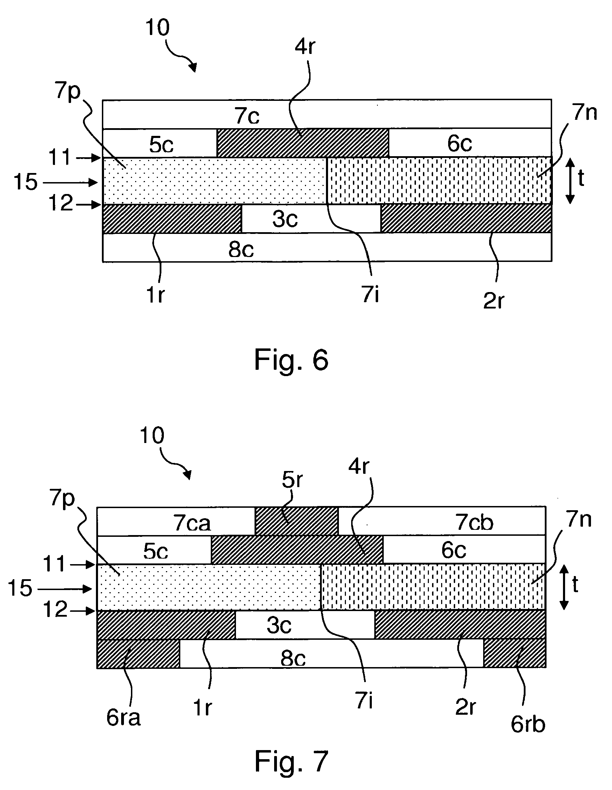

Figure 6 shows another preferred embodiment of the thermoelectric module 10. This preferred embodiment comprises fourth 7c and fifth 8c thermal bridge elements. Fourth thermal bridge element, 7c, covers second 5c and third 6c thermal bridge elements, plus third thermal resistor element 4r. Fifth thermal bridge element, 8c, covers first thermal bridge element 3c, plus first 1 r and second 2r thermal resistor elements. Preferably, fourth 7c and fifth 8c thermal bridge elements comprise a material that is an electrical conductor. Figure 7 shows another preferred embodiment of the thermoelectric module 10. Compared to the preferred embodiment shown in figure 6, fourth thermal bridge element 7c of the preferred embodiment shown in figure 7 comprises two parts, 7ca and 7cb, separated by a fourth thermal resistor element 5r. Fifth thermal bridge element 8c does not cover the whole lower surface of first thermal bridge element 3c, plus first 1r and second 2r thermal resistor elements in the embodiment shown in figure 7. Two parts 6ra and 6rb of a fifth thermal resistor element 6r are separated by the fifth thermal bridge element 8c in this preferred embodiment. The configurations shown in figures 6 and 7 allow increasing the power efficiency of the thermoelectric module 10.

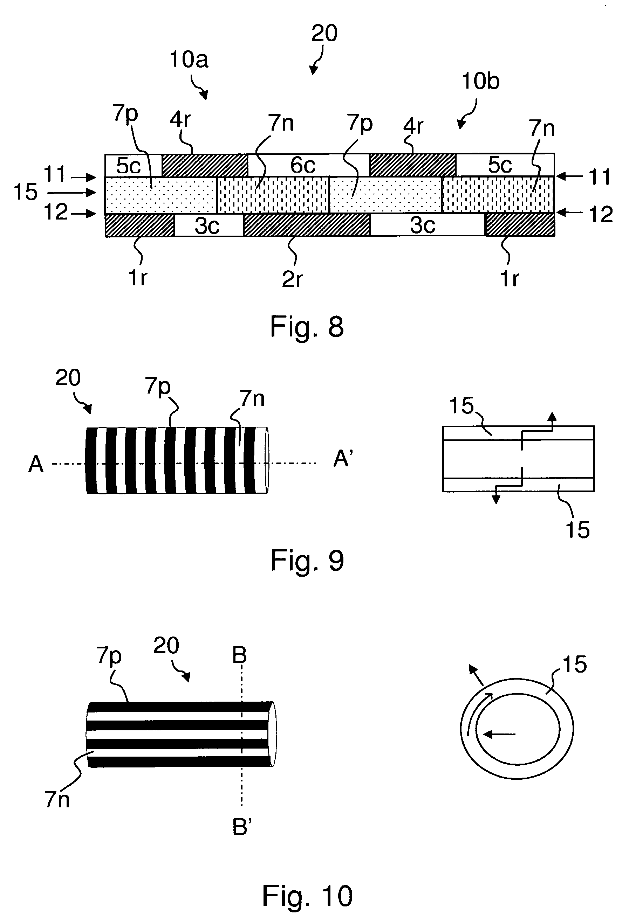

According to a second aspect, the invention relates to an assembly 20 of a first 10a and a second 10b thermoelectric modules, as shown in figure 8. The upper 11 and lower 12 main surfaces of the first thermoelectric module 10a (or of the thermoelectric layer of the first thermoelectric module 10a) are continuous with respectively the upper 11 and lower 12 main surfaces of the second 10b thermoelectric module (or of the thermoelectric layer of the second thermoelectric module 10b). Moreover, the n-type portion 7n of the first thermoelectric module 10a is electrically and mechanically coupled to the p-type portion 7p of the second thermoelectric module 10b. The assembly 20 preferably comprises more than two thermoelectric modules 10. In this preferred embodiment, the electric currents generated in each portions of the thermoelectric layer add when a temperature gradient is applied between the upper 11 and the lower 12 main surfaces of the thermoelectric modules. Hence, by providing electric contacts to the p-type 7p portion of the first thermoelectric module 10a and to the n-type 7n portion of the second thermoelectric module 10b, electric power can be extracted from the assembly 20 when a temperature gradient is imposed between the upper 11 and the lower 12 main surfaces. According to a preferred embodiment, the assembly 20 comprises the fourth thermal bridge element 7c and the fifth thermal bridge element 8c shown on figure 6 and extending along the top and lower surfaces of the assembly 20. According to another preferred embodiment, the assembly 20 comprises a fourth thermal bridge element 7c comprising at least two parts, 7ca and 7cb, separated by a fourth thermal resistor element 5r (as shown in figure 7). In this last preferred embodiment, fifth thermal bridge element 8c does not cover the whole lower surface of the assembly 20. At least two parts 6ra and 6rb of a fifth thermal resistor element 6r are separated by the fifth thermal bridge element 8c in this preferred embodiment.

Even if the geometries shown in figures 1 to 8 are planar, such a feature is not required for the thermoelectric module 10 of the invention. Hence, the thermoelectric layer 15 of the thermoelectric modules 10 or of the assembly 20 of the invention can have a cylindrical shape. Such a shape is particularly useful when one aims at using heat in chimneys for generating electric power. Left parts of figures 9 and 10 show two examples of an assembly 20 according to the invention where the thermoelectric layer 15 has a cylindrical shape. For clarity reasons, the thermal resistor elements and the thermal bridge elements are not shown in these two figures. The assemblies 20 of figures 9 and 10 comprise more than two thermoelectric modules 10. Figure 9 can be seen as a part of an axial cross-section along the plane AA' of the left part of figure 9. Figure 8 can also be seen as a part of a radial cross-section along the plane BB' of the left part of figure 10. Figure 8 further shows the thermal resistor elements and the thermal bridge elements (1 r, 2r, 4r, 3c, 5c, 6c) and only comprises two thermoelectric modules, 10a and 10b. Right part of figure 9 shows an axial cross-section along the plane AA' of the left part of same figure. Right part of figure 10 shows a radial cross-section along the plane BB' of the left part of same figure. The different p-type and n-type portions are not shown in the right parts of figures 9 and 10 for clarity reasons. The arrows in right parts of these figures schematically show a direction of a thermal flux that takes place in the thermoelectric layer 15 of the cylindrical assemblies 20 of figures 9 and 10 when the inner temperature is higher than the outer temperature. For the geometry of figure 9, one can see that the thermal flux has then an axial component. For the geometry of figure 10, a circumferential component of the thermal flux is present when the inner temperature of the cylindrical assembly 20 is higher than its outer temperature.

The thermoelectric module 10 or the assembly 20 of the invention can be used for generating electric power from a temperature difference or for generating a temperature difference from electric power (Peltier effect).

According to a third aspect, the invention relates to a method for making a thermoelectric module 10 (figures 11 to 14). This method comprises the following steps:

> (a) forming a multilayer material 95 comprising at least two layers of at least a first and a second materials;
> (b) heating this multilayer material 95 such that the two materials of the at least two layers are blended by diffusion in order to obtain a thermoelectric layer 15 comprising an upper and a lower main surfaces (11, 12), separated by the thickness t thereof;
> (c) coupling a first and second thermal resistor elements (1 r, 2r), and a first thermal bridge element 3c in thermal contact with one main surface of said thermoelectric layer 15, wherein said first thermal bridge element 3c is gloablly able to transfer heat between said thermoelectric layer 15 and the surrounding environment at a substantially higher rate than the first and second thermal resistor elements 1 r, 2r.

Preferably the multilayer material 95 comprises three layers. Still more preferably, these three layers comprise the three following materials: iron (Fe), vanadium (V), and aluminium (Al).

Different methods can be used in step (a) for forming the multilayer material 95. Two examples of such methods are detailed below.

Once the multilayer material 95 has been formed in step (a), a heat treatment is applied to it. Such a heat treatment allows obtaining a mixing of the different materials of the different layers of the multilayer material 95 by diffusion. Such heat treatments are commonly used by the one skilled in the art when one aims at obtaining a material having homogeneous properties. Preferably, the heat treatment of the multilayer material 95 is carried out under controlled atmosphere. More preferably, an atmosphere comprising 95% of argon and 5% of hydrogen is used. As known by the one skilled in the art, a heat treatment under controlled atmosphere allows preventing oxidation of the multilayer material 95.

When one aims at obtaining a thermoelectric layer 15 comprising a Fe, V, Al-based material, a multilayer material 95 comprising a layer of each of such material (Fe, V, Al) is made in a first time (step (a)). Then, a heat treatment is applied to the obtained multilayer material 95 with the following preferred parameters. Temperatures higher than 1400 °C are preferably used during the heat treatment of step (b). Such high temperatures allow obtaining a good diffusion of each material through the whole thickness of the multilayer material 95 formed in step (a). The duration of the heat treatment of step (b) when Fe, V, and Al materials are used for forming the multilayer material is preferably comprised between 1 and 17 hours, depending on the thickness of the multilayer material 95. More preferably, if the thickness of the multilayer material is larger than 1.5 mm, duration longer than 17 hours is used for still increasing the homogeneity of the resulting $Fe_2VAl$ phase.

A local doping of the multilayer material 95 is preferably carried out in order to obtain a thermoelectric layer 15 having different portions with different doping levels. When a thermoelectric layer 15 comprising Fe, V, and Al is used, such a doping process allows significantly increasing the thermoelectric properties of the thermoelectric layer 15, see for instance H. Matsuura, et al. in "Doping effects on thermoelectric properties of the pseudogap Fe2VAl system", J.Japan Inst, Metals, Vol. 66, No. 7, pp. 767-771, (2002). When the thermoelectric layer 15 comprises Fe, V, and Al, adding silicon (Si) allows obtaining n-type portions whereas adding titanium (Ti) allows obtaining p-type portions. Other doping elements could be used. The doping of the thermoelectric layer 15 is preferably carried out during the heat treatment of step (b) of the method of the invention. However, the doping of the thermoelectric layer 15 can be carried out before or after the heat treatment of step (b) of the method of the invention. The one skilled in the art generally names such a doping process as doping by diffusion.

The different p-type and n-type portions of the thermoelectric layer 15 can also be induced by local stoichiometry variations of the material of the thermoelectric layer 15. If one slightly and locally changes the stoichiometry of the alloy $Fe_2VAl$ by locally modifying the concentrations of Fe, V, and Al, p-type or n-type portions of this alloy can be obtained. Local modifications of the elements concentration of this alloy can be achieved by providing before step (a) layers of different materials having a predetermined shape. Figure 11 illustrates this doping technique for the $Fe_2VAl$ alloy. First (left part of figure 11), an aluminium (Al) layer 80 having slots is provided. Then a layer of vanadium (V) 85 is stacked between this aluminum layer 80 and a top iron (Fe) layer 90 (middle part of figure 11). After (right part of figure 11), a multilayer material 95 comprising three layers in this case is formed (step (a) of the method of the invention). In the example shown in figures 11 and 12, the multilayer material 95 is formed by using a roll bonding process as shown in the right part of figure 11 (details of this process are given below). After, the multilayer material 95 undergoes a heat treatment (step (b) of the method of the invention). At the end of the heat treatment, a thermoelectric layer 15 having an alternation of p-type 7p and n-type 7n portions is formed (right part of figure 12).

In step (c) of the method of the invention, the first and second thermal resistor elements (1 r, 2r), and the first thermal bridge element 3c are coupled to the thermoelectric layer 15. When the thermoelectric module 10 further comprises a third thermal resistor element 4r, and second and third thermal bridge elements (5c,6c), step (b) of the method of the invention also includes the coupling of these last elements to one main surface of the thermoelectric layer 15. As explained above, different techniques known by the one skilled in the art can be used for coupling the elements (1 r, 2r, 3c) and possibly also the elements (4r,5c,6c) to the thermoelectric layer 15. Examples of such techniques are: printing (such as lithography), local oxidation techniques, and gluing.

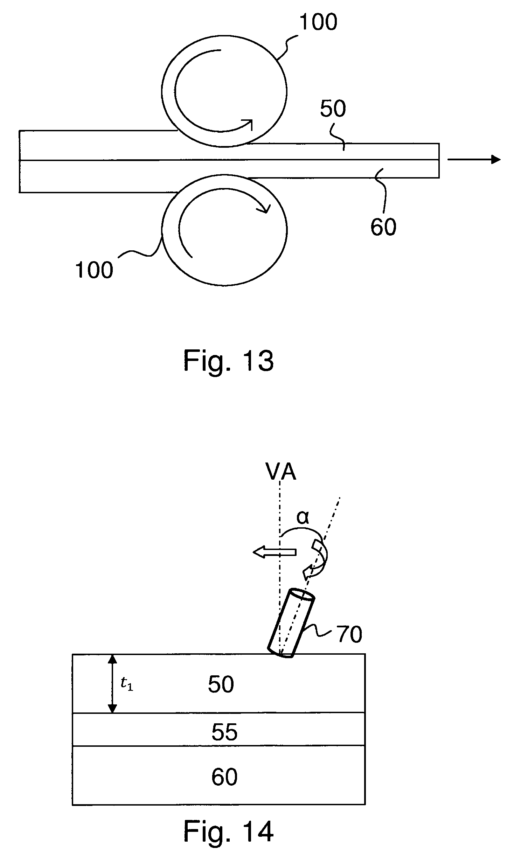

Preferably, a roll bonding process that is known by the one skilled in the art is used for step (a) of the method of the invention. Roll bonding is a process that allows joining different layers by stacking them and after by passing and pressing the obtained layup (or stack) between rolls 100. Figure 13 schematically shows a roll bonding process where it is assumed that the multilayer material 95 comprises two layers 50, 60. To obtain a joint of good quality between the two layers (50, 60), the atoms of the two materials of these layers must typically be brought to a distance lower than $5*10^{-10}$ m approximately. Preferably, high deformation rates are induced during the roll bonding process to allow a damage of a possible oxide layer covering the layers (50, 60) before rolling. Preferably, the speed of the layup at the exit of the rolls is comprised between 10 and 100 m/min. Roll bonding can be hot or cold depending on the type of materials to join. Preferably, before passing and pressing the layup between the rolls 100, the surfaces of the at least two layers are cleaned for removing dust or grease. One can also apply a dedicated surface treatment such as brushing or polishing to decrease the thickness of a possible oxide layer covering the at least two layers.

Preferably, a method derived from Friction Stir Processing (FSP) is used for step (a). This method is preferably used when the multilayer material 95 of step (a) has three layers and comprises the following steps.

- a first layer 50 of a first material, a second layer 55 of a second material, and a third layer 60 of a third material are provided such that the melting temperature of the second material, $T_{m,2}$, is lower than the melting temperatures of the first and third materials, $T_{m,1}$ and $T_{m,3}$, where the first, second and third layers each have an upper surface and a lower surface;

- forming a layup by stacking the first 50, second 55 and third 60 layers such that the upper surface of the second layer 55 contacts at least a portion of the lower surface of the first layer 50, such that the lower surface of the second layer 55 contacts at least a portion of the upper surface of the third layer 60, and such that the contact portions of the upper and lower surfaces of the second layer 55 with the first and third layers, respectively, overlap at least partially;

- pressing and translating over at least a friction portion of the upper surface of the first layer 50 a rotating tool 70 to raise the temperature of said friction portion of the upper surface of the first layer 50 by friction and to conduct heat through the thickness, $t_1$, of the first layer 50 to the second layer 55 such that the temperatures reached by at least the overlapping portions of the upper and lower surfaces of the second layer 55 are higher than the second melting temperature $T_{m,2}$ thereof.

This method is illustrated in figure 14. The multilayer material 95 is formed following the melting of the second layer 55 at the contact portions where the second layer 55 contacts the first 50 and third 60 layers.

Preferably, the rotating tool 70 has a cylindrical shape. In this case, its axis of revolution is preferably tilted of an angle $\alpha$ with respect to a vertical axis VA that is perpendicular to the upper surface of the first layer 50. Preferably, in order to increase the heat that is generated, the rotating tool 70 penetrates the first layer 50 by about 100 $\mu$m when it is translated over the friction portion of the upper surface of the first layer 50. Preferably, the speed of rotation of the rotating tool 70 is comprised between 500 and 3000 revolutions per minute. More preferably, this speed of rotation is equal to 2000 revolutions per minute. Preferably, the rotating tool 70 is made of a material comprising cemented carbide (K20), or tungsten carbide. Preferably, the rotating tool 70 is translated over the friction portion of the upper surface of the first layer 50 with a speed comprised between 50 and 400 mm/min.

The present invention has been described in terms of specific embodiments, which are illustrative of the invention and not to be construed as limiting. More generally, it will be appreciated by persons skilled in the art that the present invention is not limited by what has been particularly shown and/or described hereinabove. Reference numerals in the claims do not limit their protective scope. Use of the verbs "to comprise", "to include", "to be composed of", or any other variant, as well as their respective conjugations, does not exclude the presence of elements other than those stated. Use of the article "a", "an" or "the" preceding an element does not exclude the presence of a plurality of such elements.

Summarized, the invention may also be described as follows. According to a first aspect, the invention relates to a thermoelectric module 10 that comprises a thermoelectric layer 15 comprising one p-type 7p and one n-type 7n portions presenting together an upper and a lower main surfaces (11,12). The thermoelectric module 10 further comprises a first and a second thermal resistor elements (1 r, 2r), and a first thermal bridge element 3c between and adjacent to the first and second thermal resistor elements (1 r, 2r). The first and second thermal resistor elements (1 r, 2r) and the first thermal bridge element 3c cover the whole lower main surface 12. The p-type 7p and the n-type 7n portions are adjacent and directly coupled by an interface 7i. The first thermal bridge element 3c spans at least over the orthogonal projection of the interface 7i on the lower main surface 12. According to a second aspect, the invention relates to an assembly 20 of such thermoelectric modules 10. According to a third aspect, the invention relates to a method for making such thermoelectric modules 10.

## Claims

1. Thermoelectric module (10) comprising:

   - a thermoelectric layer (15) of substantially constant thickness, t, comprising one p-type portion (7p) and one n-type portion (7n), both portions (7p, 7n) presenting together an upper and a lower main surfaces (11,12) separated by said thickness t and extending over the whole thickness t of the thermoelectric layer (15);
   - first and second thermal resistor elements (1 r, 2r) in thermal contact with said lower main surface (12);
   - a first thermal bridge element (3c) in thermal contact with said lower main surface (12), between and adjacent to the first and second thermal resistor elements (1 r, 2r);

   such that said first and second thermal resistor elements (1 r, 2r) and said first thermal bridge element (3c) cover the whole lower main surface (12), and such that said first thermal bridge element (3c) is globally able to transfer heat between said thermoelectric layer (15) and the surrounding environment at a substantially higher rate than the first and second thermal resistor elements (1 r, 2r); wherein:

   - said p-type (7p) and said n-type (7n) portions are adjacent and directly coupled by an interface (7i); and in that
   - said first thermal bridge element (3c) spans at least over the orthogonal projection of said interface (7i) onto said lower main surface (12).

2. Thermoelectric module (10) according to claim 1 **characterized in that** said first thermal bridge element (3c) has a third thermal conductivity, $\kappa_3$, that is higher than the thermal conductivities of said first and second thermal resistor elements (1 r, 2r), $\kappa_1$ and $\kappa_2$.

3. Thermoelectric module (10) according to claim 1 or 2 **characterized in that** said p-type portion (7p) and said n-type portion (7n) have substantially the same volume, and **in that**, each of said first and second thermal resistor elements (1 r, 2r) covers at least 30% of said lower main surface (12).

4. Thermoelectric module (10) according to any of previous claims **characterized in that**:

   - said thermoelectric layer (15) has a breadth B; and **in that**
   - said p-type (7p) and n-type (7n) portions extend over substantially the whole breadth B.

5. Thermoelectric module (10) according to any of previous claims **characterized in that** the thickness t of the thermoelectric layer (15) is comprised between 1 and 10 mm.

6. Thermoelectric module (10) according to any of previous claims further comprising :

   - a third thermal resistor element (4r) in thermal contact with said upper main surface (11);
   - second and third thermal bridge elements (5c, 6c) in thermal contact with said upper main surface (11);

   wherein:

   - said third thermal resistor element (4r) is globally able to transfer heat between said thermoelectric layer (15) and the surrounding environment at a substantially lower rate than second and third thermal bridge elements (5c, 6c);
   - said third thermal resistor element (4r) and said second and third thermal bridge elements (5c, 6c) cover the whole upper main surface (11); and wherein
   - said third thermal resistor element (4r) spans at least over the orthogonal projection of said electrical interface (7i) onto said upper main surface (11).

7. Thermoelectric module (10) according to claim 6 **characterized in that** said third thermal resistor element (4r) has a fourth thermal conductivity, $\kappa_4$, that is lower than the thermal conductivities of said second and third thermal bridge elements (5c, 6c), $\kappa_5$ and $\kappa_6$.

8. Thermoelectric module (10) according to claim 6 or 7 **characterized in that** said third thermal resistor element (4r) covers at least 50% of the orthogonal projection of said first thermal bridge element (3c) on said upper main surface (11).

9. Thermoelectric module (10) according to any of claims 6 to 8 **characterized in that** said third thermal resistor element (4r) covers at least 100% of the orthogonal projection of said first thermal bridge element (3c) on said upper main surface (11).

10. Thermoelectric module (10) according to any of claims 6 to 9 **characterized in that** said first, second and third thermal resistor elements (1 r, 2r, 4r) comprise a same thermally insulating material of thermal conductivity $\kappa_r$, and **in that** said first, second and third thermal bridge element elements (3c, 5c, 6c) comprise a same thermally conductive material of thermal conductivity $\kappa_c$, and such that $\kappa_r < \kappa_c$.

11. Thermoelectric module (10) according to any of previous claims **characterized in that** said thermoelectric layer (15) comprises a Fe,V,Al-based material.

12. Assembly (20) of a first (10a) and a second (10b) thermoelectric modules according to any of previous claims **characterized in that**:

- the upper (11) and lower (12) main surfaces of the first thermoelectric module (10a) are continuous with respectively the upper (11) and lower (12) main surfaces of the second (10b) thermoelectric module; and **in that**
- the n-type portion (7n) of the first thermoelectric module (10a) is electrically and mechanically coupled to the p-type portion (7p) of the second thermoelectric module (10b).

13. Method for making a thermoelectric module (10) according to any of claims 1 to 11 comprising the following steps :

(a) forming a multilayer material (95) comprising at least two layers of at least first and second materials;
(b) heating this multilayer material (95) such that the at least two materials of the at least two layers are blended by diffusion in order to obtain a thermoelectric layer (15) comprising an upper and a lower main surfaces (11, 12), separated by the thickness t thereof;
(c) coupling a first and second thermal resistor elements (1 r, 2r), and a first thermal bridge element (3c) in thermal contact with one main surface of said thermoelectric layer (15), wherein said first thermal bridge element (3c) is globally able to transfer heat between said thermoelectric layer (15) and the surrounding environment at a substantially higher rate than the first and second thermal resistor elements (1 r, 2r).

14. Method according to claim 13 **characterized in that** the multilayer material (95) is formed in step (a) by a roll bonding process.

15. Method according to claim 13 **characterized in that** the multilayer material (95) is formed in step (a) by performing the following steps:

- providing a first layer (50) of a first material, a second layer (55) of a second material, and a third layer (60) of a third material such that the melting temperature of the second material, $T_{m,2}$, is lower than the melting temperatures of the first and third materials, $T_{m,1}$ and $T_{m,3}$, where the first (50), second (55) and third (60) layers each have an upper surface and a lower surface;
- forming a layup by stacking the first (50), second (55) and third (60) layers such that the upper surface of the second layer (55) contacts at least a portion of the lower surface of the first layer (50), such that the lower surface of the second layer (55) contacts at least a portion of the upper surface of the third layer (60), and such that the contact portions of the upper and lower surfaces of the second layer (55) with the first (50) and third (60) layers, respectively, overlap at least partially;
- pressing and translating over at least a friction portion of the upper surface of the first layer (50) a rotating tool (70) to raise the temperature of said friction portion of the upper surface of the first layer (50) by friction and to conduct heat through the thickness, $t_1$, of the first layer (50) to the second layer (55) such that the temperatures reached by at least the overlapping portions of the upper and lower surfaces of the second layer (55) are higher than the second melting temperature $T_{m,2}$ thereof.

## Patentansprüche

1. Thermoelektrisches Modul (10) mit:

- einer thermoelektrischen Schicht (15) von einer wesentlich konstanten Dicke t, die einen p-leitenden Teil (7p) und einen n-leitenden Teil (7n) umfasst, wobei beide Teile (7p, 7n) zusammen eine obere und eine untere Hauptfläche (11, 12) darstellen, welche durch die Dicke t voneinander getrennt sind und die sich über die gesamte Dicke t der thermoelektrischen Schicht (15) erstrecken,
- ersten und zweiten Thermistorelementen (1r, 2r) in einem thermischen Kontakt mit der unteren Hauptfläche (12),
- einem ersten thermischen Brückenelement (3c) in einem thermischen Kontakt mit der unteren Hauptfläche (12) zwischen dem und benachbart zu dem ersten und dem zweiten Thermistorelement (1r, 2r),

derart, dass das erste und das zweite Thermistorelement (1r, 2r) und das erste thermische Brückenelement (3c) die gesamte untere Hauptfläche (12) abdecken, und derart, dass das erste thermische Brückenelement (3c) übergreifend in der Lage ist, Wärme zwischen der thermoelektrischen Schicht (15) und der umliegenden Umgebung mit einer wesentlich höheren Rate als das erste und das zweite Thermistorelement (1r, 2r) zu übertragen, wobei:

- der p-leitende (7p) und der n-leitende Teil (7n) benachbart und über eine Trennfläche (7i) direkt gekoppelt sind und
- das erste thermische Brückenelement (3c) mindestens die orthogonale Projektion der Trennfläche (7i) auf die untere Hauptfläche (12) überspannt.

2. Thermoelektrisches Modul (10) nach Anspruch 1, **dadurch gekennzeichnet, dass** das erste thermische Brückenelement (3c) eine dritte thermische Leitfähigkeit $\kappa_3$ aufweist, die höher als die thermischen Leitfähigkeiten des ersten und des zweiten Thermistorelements (1r, 2r) $\kappa_1$ und $\kappa_2$ ist.

3. Thermoelektrisches Modul (10) nach Anspruch 1 oder 2, **dadurch gekennzeichnet, dass** der p-leitende Teil (7p) und der n-leitende Teil (7n) im Wesentlichen das gleiche Volumen aufweisen, und dadurch, dass jeweils das erste und das zweite Thermistorelement (1r, 2r) mindestens 30% der unteren Hauptfläche (12) abdeckt.

4. Thermoelektrisches Modul (10) nach einem der vorhergehenden Ansprüche, **dadurch gekennzeichnet, dass**:

- die thermoelektrische Schicht (15) eine Breite B aufweist, und dadurch, dass
- sich der p-leitende Teil (7p) und der n-leitende Teil (7n) im Wesentlichen über die gesamte Breite B erstrecken.

5. Thermoelektrisches Modul (10) nach einem der vorhergehenden Ansprüche, **dadurch gekennzeichnet, dass** die Dicke t der thermoelektrischen Schicht (15) zwischen 1 und 10 mm liegt.

6. Thermoelektrisches Modul (10) nach einem der vorhergehenden Ansprüche, ferner umfassend:

- ein drittes Thermistorelement (4r) in einem thermischen Kontakt mit der oberen Hauptfläche (11),
- zweites und drittes thermisches Brückenelement (5c, 6c) in einem thermischen Kontakt mit der oberen Hauptfläche (11),

wobei:

- das dritte Thermistorelement (4r) übergreifend in der Lage ist, Wärme zwischen der thermoelektrischen Schicht (15) und der umliegenden Umgebung mit einer wesentlich niedrigeren Rate als das zweite und das dritte thermische Brückenelement (5c, 6c) zu übertragen,
- das dritte Thermistorelement (4r) und das zweite und das dritte thermische Brückenelement (5c, 6c) die gesamte obere Hauptfläche (11) abdecken, und wobei
- das dritte Thermistorelement (4r) mindestens die orthogonale Projektion der elektrischen Trennfläche (7i) auf die obere Hauptfläche (11) überspannt.

7. Thermoelektrisches Modul (10) nach Anspruch 6, **dadurch gekennzeichnet, dass** das dritte Thermistorelement (4r) eine vierte thermische Leitfähigkeit $\kappa_4$ aufweist, die niedriger als die thermischen Leitfähigkeiten des zweiten und des dritten thermischen Brückenelements (5c, 6c) $\kappa_5$ und $\kappa_6$ ist.

8. Thermoelektrisches Modul (10) nach Anspruch 6 oder 7, **dadurch gekennzeichnet, dass** das dritte Thermistorelement (4r) mindestens 50% der orthogonalen Projektion des ersten thermischen Brückenelements (3c) auf die obere Hauptfläche (11) abdeckt.

9. Thermoelektrisches Modul (10) nach einem der Ansprüche 6 bis 8, **dadurch gekennzeichnet, dass** das dritte Thermistorelement (4r) mindestens 100% der orthogonalen Projektion des ersten thermischen Brückenelements (3c) auf die obere Hauptfläche (11) abdeckt.

10. Thermoelektrisches Modul (10) nach einem der Ansprüche 6 bis 9, **dadurch gekennzeichnet, dass** das erste, das zweite und das dritte Thermistorelement (1r, 2r, 4r) ein gleiches thermisch isolierendes Material mit der thermischen Leitfähigkeit $\kappa_r$ umfassen, und dadurch, dass das erste, das zweite und das dritte thermische Brückenelement (3c, 5c, 6c) ein gleiches thermisch leitfähiges Material mit der thermischen Leitfähigkeit $\kappa_c$ umfassen, und derart, dass $\kappa_r < \kappa_c$ ist.

**11.** Thermoelektrisches Modul (10) nach einem der vorhergehenden Ansprüche, **dadurch gekennzeichnet, dass** die thermoelektrische Schicht (15) ein Material auf Fe-, V-, Al-Basis umfasst.

**12.** Anordnung (20) aus einem ersten (10a) und einem zweiten (10b) thermoelektrischen Modul nach einem der vorhergehenden Ansprüche, **dadurch gekennzeichnet, dass**:

> - die obere (11) und die untere (12) Hauptfläche des ersten thermoelektrischen Moduls (10a) jeweils durchgehend mit der oberen (11) bzw. unteren (12) Hauptfläche des zweiten thermoelektrischen Moduls (10b) sind, und dadurch, dass
> - der n-leitende Teil (7n) des ersten thermoelektrischen Moduls (10a) elektrisch und mechanisch an den p-leitenden Teil (7p) des zweiten thermoelektrischen Moduls (10b) gekoppelt ist.

**13.** Verfahren zur Herstellung eines thermoelektrischen Moduls (10) nach einem der Ansprüche 1 bis 11, die folgenden Schritte umfassend:

> (a) Ausbilden eines Mehrschichtmaterials (95), das mindestens zwei Schichten mindestens aus ersten und zweiten Materialien umfasst,
> (b) Erhitzen dieses Mehrschichtmaterials (95) derart, dass die mindestens zwei Materialien von den mindestens zwei Schichten durch Diffusion ineinander übergehen, um eine thermoelektrische Schicht (15) zu erhalten, die eine obere und eine untere Hauptfläche (11, 12) umfasst, die durch deren Dicke t voneinander getrennt sind,
> (c) Koppeln eines ersten und eines zweiten Thermistorelements (1r, 2r) und eines ersten thermischen Brückenelements (3c) in einem thermischen Kontakt mit einer Hauptfläche der thermoelektrischen Schicht (15), wobei das erste thermische Brückenelement (3c) übergreifend in der Lage ist, Wärme zwischen der thermoelektrischen Schicht (15) und der umliegenden Umgebung mit einer wesentlich höheren Rate als das erste und das zweite Thermistorelement (1r, 2r) zu übertragen.

**14.** Verfahren nach Anspruch 13, **dadurch gekennzeichnet, dass** das Mehrschichtmaterial (95) in einem Schritt (a) durch einen Walzplattierprozess ausgebildet wird.

**15.** Verfahren nach Anspruch 13, **dadurch gekennzeichnet, dass** das Mehrschichtmaterial (95) in einem Schritt (a) ausgebildet wird, indem die folgenden Schritte ausgeführt werden:

> - Bereitstellen einer ersten Schicht (50) aus einem ersten Material, einer zweiten Schicht (55) aus einem zweiten Material und einer dritten Schicht (60) aus einem dritten Material derart, dass die Schmelztemperatur des zweiten Materials $T_{m,2}$ niedriger als die Schmelztemperaturen des ersten und des dritten Materials, $T_{m,1}$ und $T_{m,3}$, sind, wobei die erste (50), zweite (55) und dritte (60) Schicht jeweils eine obere und eine untere Fläche aufweisen,
> - Ausbilden einer Aufschichtung durch Aufstapeln der ersten (50), zweiten (55) und dritten (60) Schicht derart, dass die obere Fläche der zweiten Schicht (55) mindestens einen Teil der unteren Fläche der ersten Schicht (50) kontaktiert, derart, dass die untere Fläche der zweiten Schicht (55) mindestens einen Teil der oberen Fläche der dritten Schicht (60) kontaktiert, und derart, dass sich die Kontaktteile der oberen und unteren Fläche der zweiten Schicht (55) mit der ersten (50) bzw. der dritten Schicht (60) mindestens teilweise überlappen,
> - Pressen und Verschieben eines Rotationswerkzeugs (70) mindestens über einen Reibungsteil der oberen Fläche der ersten Schicht (50), um die Temperatur des Reibungsteils der oberen Fläche der ersten Schicht (50) durch Reibung zu erhöhen und Wärme durch die Dicke $t_1$ der ersten Schicht (50) derart zur zweiten Schicht (55) hindurch zu leiten, dass die Temperaturen, die mindestens von den sich überlappenden Teilen der oberen und der unteren Fläche der zweiten Schicht (55) erreicht werden, höher als deren zweite Schmelztemperatur $T_{m,2}$ ist.

## Revendications

**1.** Module thermoélectrique (10) comprenant :

> - une couche thermoélectrique (15) d'une épaisseur t sensiblement constante, comprenant une partie (7p) de type p et une partie (7n) de type n, les deux parties (7p, 7n) présentant ensemble une surface principale supérieure (11) et une surface principale inférieure (12) séparées par ladite épaisseur t et s'étendant sur la totalité de l'épaisseur t de la couche thermoélectrique (15) ;
> - un premier élément et un deuxième élément à résistance thermique (1r, 2r) en contact thermique avec ladite surface principale inférieure (12) ;
> - un premier élément à pont thermique (3c) en contact thermique avec ladite surface principale inférieure (12), ledit élément à pont thermique étant situé entre et adjacent aux premier et deuxième éléments à résistance thermique (1r, 2r) ; de sorte que lesdits premier et deuxième éléments à résistance thermique (1r, 2r) et ledit premier élément à pont thermique (3c) couvrent la totalité de la surface principale inférieure (12), et de sorte que ledit premier élément à pont thermique (3c) est globalement capable de transférer de la chaleur entre ladite couche thermoélectrique (15) et le milieu environnant, à un taux sensiblement supérieur à celui des premier et deuxième éléments à résistance thermique (1r, 2r) ;

module thermoélectrique dans lequel

- les parties dudit type p (7p) et dudit type n (7n) sont adjacentes et directement couplées par une interface (7i) ; et dans lequel
- ledit premier élément à pont thermique (3c) s'étend au moins suivant la projection orthogonale de ladite interface (7i), formée sur ladite surface principale inférieure (12).

2. Module thermoélectrique (10) selon la revendication 1, **caractérisé en ce que** ledit premier élément à pont thermique (3c) a une troisième conductivité thermique $k_3$ qui est supérieure aux conductivités thermiques desdits premier et deuxième éléments à résistance thermique (1r, 2r), et supérieure à $k_1$ et à $k_2$.

3. Module thermoélectrique (10) selon la revendication 1 ou 2, **caractérisé en ce que** ladite partie (7p) de type p et ladite partie (7n) de type n ont sensiblement le même volume, et **en ce que** chacun desdits premier et deuxième éléments à résistance thermique (1r, 2r) couvre au moins 30 % de ladite surface principale inférieure (12).

4. Module thermoélectrique (10) selon l'une quelconque des revendications précédentes, **caractérisé en ce que**

- ladite couche thermoélectrique (15) a une largeur B ; et **en ce que**
- lesdites parties de type p (7p) et de type n (7n) s'étendent sur sensiblement la totalité de la largeur B.

5. Module thermoélectrique (10) selon l'une quelconque des revendications précédentes, **caractérisé en ce que** l'épaisseur t de la couche thermoélectrique (15) est comprise entre 1 mm et 10 mm.

6. Module thermoélectrique (10) selon l'une quelconque des revendications précédentes, comprenant en outre :

- un troisième élément à résistance thermique (4r) en contact thermique avec ladite surface principale supérieure (11) ;
- un deuxième élément et un troisième élément à pont thermique (5c, 6c) en contact thermique avec ladite surface principale supérieure (11) ;

module thermoélectrique dans lequel

- ledit troisième élément à résistance thermique (4r) est globalement capable de transférer de la chaleur entre ladite couche thermoélectrique (15) et le milieu environnant, à un taux sensiblement inférieur à celui des deuxième et troisième éléments à pont thermique (5c, 6c) ;
- ledit troisième élément à résistance thermique (4r) et lesdits deuxième et troisième éléments à pont thermique (5c, 6c) couvrent la totalité de la surface principale supérieure (11) ; et dans lequel
- ledit troisième élément à résistance thermique (4r) s'étend au moins suivant la projection orthogonale de ladite interface électrique (7i), formée sur ladite surface principale supérieure (11).

7. Module thermoélectrique (10) selon la revendication 6, **caractérisé en ce que** ledit troisième élément à résistance thermique (4r) a une quatrième conductivité thermique $k_4$ qui est inférieure aux conductivités thermiques desdits deuxième et troisième éléments à pont thermique (5c, 6c), et inférieure à $k_5$ et à $k_6$.

8. Module thermoélectrique (10) selon la revendication 6 ou 7, **caractérisé en ce que** ledit troisième élément à résistance thermique (4r) couvre au moins 50 % de la projection orthogonale dudit premier élément à pont thermique (3c), formée sur ladite surface principale supérieure (11).

9. Module thermoélectrique (10) selon l'une quelconque des revendications 6 à 8, **caractérisé en ce que** ledit troisième élément à résistance thermique (4r) couvre au moins 100 % de la projection orthogonale dudit premier élément à pont thermique (3c), formée sur ladite surface principale supérieure (11).

10. Module thermoélectrique (10) selon l'une quelconque des revendications 6 à 9, **caractérisé en ce que** lesdits premier, deuxième et troisième éléments à résistance thermique (1r, 2r, 4r) comprennent un même matériau thermo-isolant de conductivité thermique $k_r$, et **en ce que** lesdits premier, deuxième et troisième éléments à pont thermique (3c, 5c, 6c) comprennent un même matériau thermoconducteur de conductivité thermique $k_c$, et de manière telle que $k_r < k_c$.

**11.** Module thermoélectrique (10) selon l'une quelconque des revendications précédentes, **caractérisé en ce que** ladite couche thermoélectrique (15) comprend un matériau à base de Fe, V, Al.

**12.** Ensemble (20) d'un premier module (10a) et d'un second module (10b) thermoélectriques selon l'une quelconque des revendications précédentes, **caractérisé en ce que**

  - les surfaces principales supérieure (11) et inférieure (12) du premier module thermoélectrique (10a) sont continues avec, respectivement, les surfaces principales supérieure (11) et inférieure (12) du second module thermoélectrique (10b) ; et **en ce que**
  - la partie (7n) de type n du premier module thermoélectrique (10a) est électriquement et mécaniquement couplée à la partie (7p) de type p du second module thermoélectrique (10b).

**13.** Procédé de fabrication d'un module thermoélectrique (10) selon l'une quelconque des revendications 1 à 11, comprenant les étapes suivantes consistant :

  (a) à former un matériau multicouche (95) comprenant au moins deux couches se composant au moins d'un premier matériau et d'un deuxième matériau ;
  (b) à chauffer ce matériau multicouche (95), de manière telle que les matériaux au moins au nombre de deux des couches au moins au nombre de deux soient mélangés par diffusion, afin d'obtenir une couche thermoélectrique (15) comprenant une surface principale supérieure (11) et une surface principale inférieure (12) séparées par l'épaisseur t de ladite couche thermoélectrique ;
  (c) à coupler un premier élément et un deuxième élément à résistance thermique (1r, 2r) et un premier élément à pont thermique (3c), en contact thermique avec une surface principale de ladite couche thermoélectrique (15), où ledit premier élément à pont thermique (3c) est globalement capable de transférer de la chaleur entre ladite couche thermoélectrique (15) et le milieu environnant, à un taux sensiblement supérieur à celui des premier et deuxième éléments à résistance thermique (1r, 2r).

**14.** Procédé selon la revendication 13, **caractérisé en ce que** le matériau multicouche (95) est formé au cours de l'étape (a), par un processus de colaminage.

**15.** Procédé selon la revendication 13, **caractérisé en ce que** le matériau multicouche (95) est formé au cours de l'étape (a), en réalisant les étapes suivantes consistant .

  - à fournir une première couche (50) d'un premier matériau, une deuxième couche (55) d'un deuxième matériau et une troisième couche (60) d'un troisième matériau, de manière telle que la température de fusion $T_{m,2}$ du deuxième matériau soit inférieure aux températures de fusion $T_{m,1}$ et $T_{m,3}$ des premier et troisième matériaux où les première (50), deuxième (55) et troisième (60) couches ont chacune une surface supérieure et une surface inférieure ;
  - à former une superposition en empilant les première (50), deuxième (55) et troisième (60) couches, de manière telle que la surface supérieure de la deuxième couche (55) soit au contact d'au moins une partie de la surface inférieure de la première couche (50), de manière telle que la surface inférieure de la deuxième couche (55) soit au contact d'au moins une partie de la surface supérieure de la troisième couche (60), et de manière telle que les parties des surfaces supérieure et inférieure de la deuxième couche (55), en contact respectivement avec les première (50) et troisième (60) couches, se recouvrent au moins partiellement ;
  - à appuyer et à déplacer par translation un outil rotatif (70), sur au moins une partie de frottement de la surface supérieure de la première couche (50), pour augmenter, par frottement, la température de ladite partie de frottement de la surface supérieure de la première couche (50), et à faire passer de la chaleur à travers l'épaisseur $t_1$ de la première couche (50), jusqu'à la deuxième couche (55), de manière telle que les températures atteintes par au moins les parties, qui se recouvrent, des surfaces supérieure et inférieure de la deuxième couche (55), soient supérieures à la deuxième température de fusion $T_{m,2}$ de ladite deuxième couche.

Fig. 1

Fig. 2

Fig. 3

Fig. 4

Fig. 5

Fig. 6

Fig. 7

Fig. 8

Fig. 9

Fig. 10

80

90

95

85

80

**Fig. 11**

95

200

15

7p    7n

**Fig. 12**

100

50

60

100

**Fig. 13**

VA

α

70

$t_1$

50

55

60

**Fig. 14**

**EP 2 845 236 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2007273572 B
- US 20110226304 A

- WO 2005020340 A

**Non-patent literature cited in the description**

- **H. MATSUURA et al.** Doping effects on thermoelectric properties of the pseudogap Fe2VAl system. *J.Japan Inst, Metals,* 2002, vol. 66 (7), 767-771